# EUROPEAN PATENT APPLICATION

(11) **EP 4 746 624 A1**
(43) Date of publication of application: **20.05.2026**
(21) Application number: 25177874.2
(22) Date of filing: 21.05.2025
(51) Int. Cl.: H10D 8/01, H10D 8/60, H10D 62/10, H10D 64/23

(54) **SEMICONDUCTOR DEVICE AND MANUFACTURING METHOD THEREOF**

(30) Priority: 18.11.2024 KR 20240164600
(71) Applicant: Samsung Electronics Co., Ltd., Suwon-si, Gyeonggi-do 16677 (KR)
(72) Inventor: NOH, Jeongin, Suwon-si, Gyeonggi-do 16677 (KR); KIM, Jae-Yoon, Suwon-si, Gyeonggi-do 16677 (KR); MIN, Chansuk, Suwon-si, Gyeonggi-do 16677 (KR); HONG, Seongjo, Suwon-si, Gyeonggi-do 16677 (KR)
(74) Representative: Kuhnen & Wacker Patent- und Rechtsanwaltsbüro PartG mbB

(57) **Abstract**

A semiconductor device and a method of manufacturing the same, the semiconductor device includes a substrate including an active region (AR), a termination region outside the active region (AR), and a peripheral region (PR) between the active and termination regions (AR, TR); a semiconductor layer having a first conductivity type on a first surface of the substrate; a doping region (133a) having a second conductivity type inside the semiconductor layer in the active region (AR); a peripheral doping region (133b) having the second conductivity type inside the semiconductor layer in the peripheral region (PR); a first electrode on the semiconductor layer, the doping and peripheral doping regions (133a, 133b); a second electrode on a second surface of the substrate; an ohmic contact layer (150) containing a metal silicide material between the peripheral doping region (133b) and the first electrode; and a first insulating pattern between the ohmic contact layer (150) and the first electrode, the first insulating pattern adjacent to the ohmic contact layer (150).

## Description

### BACKGROUND

The present disclosure relates to semiconductor devices and manufacturing methods thereof.

In the modern society, semiconductor devices are closely related to our daily lives. In particular, power semiconductor devices which are used in various fields such as the transportation field, for example, electric vehicles, trains, and electric trams, renewable energy systems, for example, solar power generation and wind power generation, and mobile devices, are becoming increasingly important. Power semiconductor devices are semiconductor devices that are usable to handle high voltage or high current, and perform functions such as power conversion and control in large power systems and high-power electronic devices. Power semiconductor devices have the ability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by reducing (and/or minimizing) power losses. Further, power semiconductor devices can be stably driven in environments such as high temperatures.

Power semiconductor devices can be categorized by their materials, and for example, there are SiC power semiconductor devices and GaN power semiconductor devices. Instead of conventional silicon (Si), SiC or GaN may be used to manufacture power semiconductor devices, whereby it is possible to compensate for disadvantages of silicon such as for example having unstable characteristics at high temperatures. SiC power semiconductor devices are resistant to high temperatures and have low power loss, making them suitable for electric vehicles, renewable energy systems, and the like. GaN power semiconductor devices require high cost, but are efficient in terms of speed, making them suitable for fast charging of mobile devices and the like.

### SUMMARY

The present disclosure provides a semiconductor device capable of relieving high-current stress when a surge voltage is applied.

Some example embodiments provide a semiconductor device that includes a substrate including an active region, a termination region outside the active region, and a peripheral region between the active region and the termination region; a semiconductor layer on a first surface of the substrate, the semiconductor layer having a first conductivity type; a doping region inside the semiconductor layer in the active region, the doping region having of a second conductivity type different than the first conductivity type; a peripheral doping region inside the semiconductor layer in the peripheral region, the peripheral doping region having the second conductivity type; a first electrode on the semiconductor layer, the doping region, and the peripheral doping region; a second electrode on a second surface of the substrate, the second surface opposite the first surface; an ohmic contact layer between the peripheral doping region and the first electrode, the ohmic contact layer containing a metal silicide material; and a first insulating pattern between the ohmic contact layer and the first electrode, the first insulating pattern being adjacent to the ohmic contact layer in a direction parallel with the first surface of the substrate.

Some example embodiments further provide a semiconductor device that includes a substrate including an active region, a termination region outside the active region, and a peripheral region between the active region and the termination region; a semiconductor layer on a first surface of the substrate, the semiconductor layer having a first conductivity type; a doping region inside the semiconductor layer in the active region, the doping region having a second conductivity type different than the first conductivity type; a peripheral doping region inside the semiconductor layer in the peripheral region, the peripheral doping region having the second conductivity type; a first electrode on the semiconductor layer, the doping region, and the peripheral doping region; a second electrode on a second surface of the substrate, the second surface being opposite the first surface; an ohmic contact layer positioned between the peripheral doping region and the first electrode, the ohmic contact layer containing a metal silicide material; and a first insulating pattern between the ohmic contact layer and the first electrode, and the first insulating pattern being adjacent to the ohmic contact layer in a direction parallel with the first surface of the substrate. One side surface of the ohmic contact layer abuts with the first insulating pattern, and an upper surface of the ohmic contact layer abuts with the first electrode.

Some example embodiments still further provide a semiconductor device that includes a semiconductor layer having a first conductivity type and being on a substrate, the semiconductor layer including a doping region and a peripheral doping region, and the doping region and the peripheral doping region having a second conductivity type different than the first conductivity type, the semiconductor layer including an active region, a termination region outside the active region, and a peripheral region between the active region and the termination region, and the doping region being in the active region and the peripheral doping region being in the peripheral region; a first insulating pattern on the semiconductor layer in the peripheral region and on the peripheral doping region; a second insulating pattern on the peripheral doping region and on the semiconductor layer in the termination region, the second insulation pattern being spaced apart from the first insulation pattern; an ohmic contact layer on the peripheral doping region between and abutting with the first insulating pattern and the second insulating pattern; and an electrode abutting the doping region and the semiconductor layer in the active region, the ohmic contact layer and the first and second insulating patterns.

Some example embodiments provide a method of manufacturing a semiconductor device that includes implanting an impurity into an upper portion of a semiconductor layer to form a doping region and a peripheral region, the semiconductor layer having a first conductivity type, and the doping region and the peripheral region having a second conductivity type different than the first conductivity type, the semiconductor layer being on a first surface of a substrate including an active region, a termination region outside the active region, and a peripheral region between the active region and the termination region, and the doping region being in the active region and the peripheral doping region being in the peripheral region; forming an insulating layer on the semiconductor layer, the doping region, and the peripheral doping region; forming a first photoresist pattern on the insulating layer; forming a first insulating pattern and a second insulating pattern by etching the insulating layer using the first photoresist pattern as a mask, the first insulating pattern being spaced apart from the second insulating pattern in a direction parallel to the first surface of the substrate; forming an ohmic contact layer on the peripheral doping region between the first insulating pattern and the second insulating pattern; removing the first photoresist pattern; forming a second photoresist pattern covering the ohmic contact layer, the second insulating pattern and a portion of the first insulating pattern; removing a portion of the first insulating pattern by etching the first insulating pattern using the second photoresist pattern as a mask; removing the second photoresist pattern; and forming a first electrode abutting the doping region, the semiconductor layer, and the ohmic contact layer.

In some example embodiments of the method of manufacturing, the implanting the impurity includes forming a plurality of additional doping regions in the active region, the plurality of additional doping regions being spaced apart for each other and from the doping region.

**In** some example embodiments of the method of manufacturing, the ohmic contact layer includes a metal silicide material, and the forming the ohmic contact layer includes annealing the ohmic contact layer.

In some example embodiments the method of manufacturing further includes implanting a termination doping region having the second conductivity type in the termination region.

In some example embodiments of the method of manufacturing, a doping concentration of the termination doping region is less than a doping concentration of the doping region and a doping concentration of the peripheral doping region.

In some example embodiments of the method of manufacturing, the termination doping region abuts with the peripheral doping region.

In some example embodiments of the method of manufacturing, the portion of the first insulating pattern removed includes portions of the first insulating pattern overlapping the active region.

In some example embodiments of the method of manufacturing, the removing the portion of the first insulating pattern is performed so that the first insulating pattern remains overlapping the doping region.

In some example embodiments of the method of manufacturing, the removing the portion of the first insulating pattern is performed so that the first insulating pattern remains overlapping the semiconductor layer in the active region.

Some example embodiments still further provide a method of manufacturing a semiconductor device that includes forming a semiconductor layer having a first conductivity type on a substrate, the semiconductor layer including an active region, a termination region outside the active region, and a peripheral region between the active region and the termination region; implanting a doping region and a peripheral region in the semiconductor layer, the doping region and the peripheral region having a second conductivity type different than the first conductivity type, and the doping region being in the active region and the peripheral doping region being in the peripheral region; forming a first insulating pattern on the semiconductor layer in the peripheral region and on the peripheral doping region; forming a second insulating pattern on the peripheral doping region and on the semiconductor layer in the termination region, the second insulation pattern being spaced apart from the first insulation pattern; forming an ohmic contact layer on the peripheral doping region between and abutting with the first insulating pattern and the second insulating pattern; and forming an electrode abutting the doping region and the semiconductor layer in the active region, the ohmic contact layer and the first and second insulating patterns.

According to some example embodiments, it is possible to protect the semiconductor device from high-current stress when a surge voltage is applied.

### BRIEF DESCRIPTION OF THE DRAWINGS

FIG. 1 is a plan view of a semiconductor device according to some example embodiments.
FIG. 2 is a cross-sectional view taken along line A-A' of FIG. 1.
FIG. 3 is a cross-sectional view taken along line B-B' of FIG. 1.
FIG. 4 is a cross-sectional view taken along line C-C' of FIG. 1.
FIG. 5 is a cross-sectional view taken along line A-A' of FIG. 1.
FIG. 6 is a cross-sectional view taken along line B-B' of FIG. 1.
FIG. 7 is a cross-sectional view taken along line C-C' of FIG. 1.
FIG. 8 is a cross-sectional view taken along line A-A' of FIG. 1.
FIG. 9 is a cross-sectional view taken along line B-B' of FIG. 1.
FIG. 10 is a cross-sectional view taken along line C-C' of FIG. 1.
FIGS. 11, 12, 13, 14, 15, 16, 17, 18, 19 and 20 are cross-sectional views illustrating processes of manufacturing a semiconductor device according to some example embodiments in the order of the processes.

### DETAILED DESCRIPTION

In the following detailed description, some example embodiments have been shown and described, simply by way of illustration. The present inventive concepts can be variously implemented and are not limited to the following some example embodiments.

The drawings and description are to be regarded as illustrative in nature and not restrictive. Like reference numerals designate like elements throughout the specification.

The size and thickness of each configuration shown in the drawings are arbitrarily shown for understanding and ease of description, but the present inventive concepts are not limited thereto. In the drawings, the thickness of layers, films, panels, regions, etc., are exaggerated for clarity. Further, in the drawings, for understanding and ease of description, the thickness of some layers and areas is exaggerated.

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

Unless explicitly described to the contrary, the word "comprise", and variations such as "comprises" or "comprising", will be understood to imply the inclusion of stated elements but not the exclusion of any other elements.

Further, when a target part is referred to as "on a plane", it means that the target part is viewed from above, and when a target part is referred to as "on a cross-section", it means the cross-section obtained by cutting the target part vertically is viewed from the side.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

Also, for example, "at least one of A, B, and C" and similar language (e.g., "at least one selected from the group consisting of A, B, and C") may be construed as A only, B only, C only, or any combination of two or more of A, B, and C, such as, for instance, ABC, AB, BC, and AC.

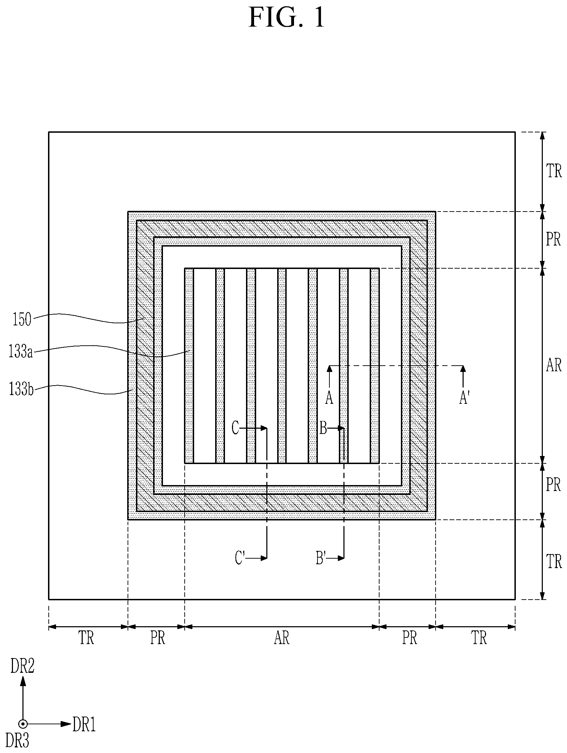

Hereinafter, a semiconductor device according to some example embodiments will be described with reference to FIGS. 1 to 4.

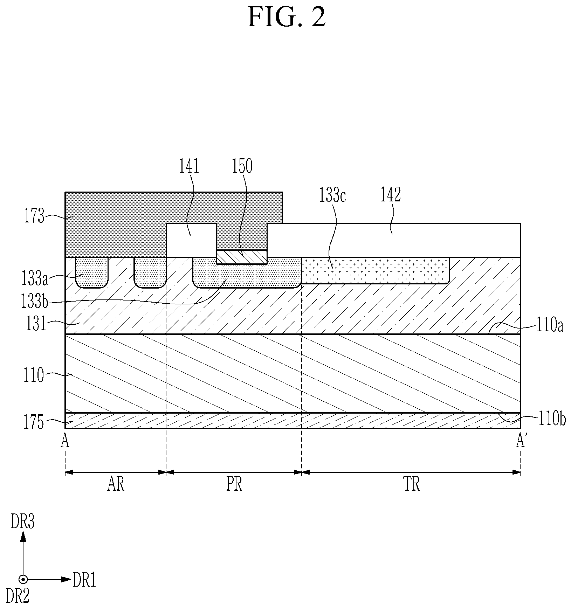

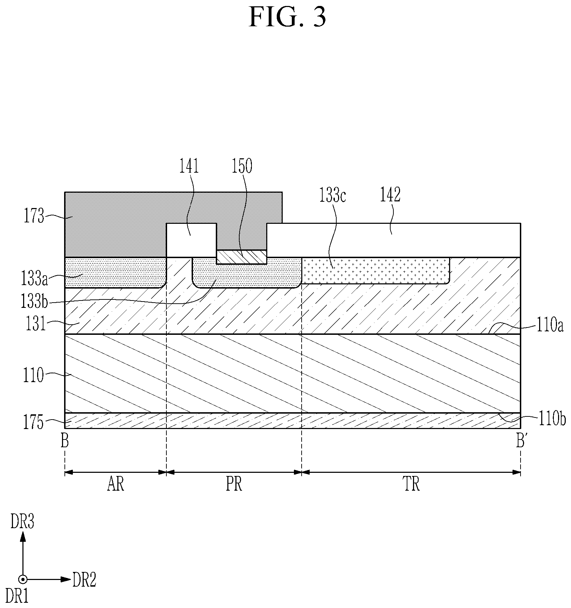

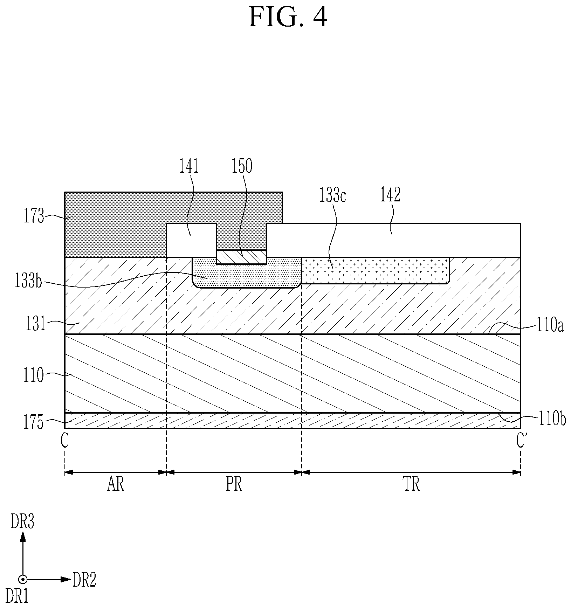

FIG. 1 is a plan view of a semiconductor device according to some example embodiments. FIG. 2 is a cross-sectional view taken along line A-A' of FIG. 1. FIG. 3 is a cross-sectional view taken along line B-B' of FIG. 1. FIG. 4 is a cross-sectional view taken along line C-C' of FIG. 1.

Referring to FIGS. 1 to 4, a semiconductor device according to some example embodiments may include a substrate 110 that includes an active region AR, a termination region TR positioned on the outside of the active region AR, and a peripheral region PR positioned between the active region AR and the termination region TR, a semiconductor layer 131 of a first conductivity type that is positioned on a first surface 110a of the substrate 110, a doping region 133a of a second conductivity type that is positioned inside the semiconductor layer 131 in the active region AR, a peripheral doping region 133b of the second conductivity type that is positioned inside the semiconductor layer 131 in the peripheral region PR, a first electrode 173 that is positioned on the semiconductor layer 131 and the doping region 133a, and a second electrode 175 that is positioned on a second surface 110b of the substrate 110 facing the first surface 110a of the substrate 110. The semiconductor device according to some example embodiments may include an ohmic contact layer 150 that is positioned between the peripheral doping region 133b and the first electrode 173 and contains a material different from that of the first electrode 173, and a first insulating pattern 141 that is positioned between the ohmic contact layer 150 and the first electrode 173 and positioned so as to abut the ohmic contact layer 150 in a direction parallel with the first surface 110a of the substrate 110.

The substrate 110 may be a semiconductor substrate containing SiC. For example, the substrate 110 may consist of a 4H SiC substrate. In some example embodiments, the substrate 110 may consist of a 3C SiC substrate, a 6H SiC substrate, or the like. The substrate 110 may be doped with a first conductivity type impurity. For example, the first conductivity type impurity may be an n-type impurity. For example, the substrate 110 may be doped into an n-type. The substrate 110 may be doped into an n-type at a high concentration. The resistivity of the substrate 110 may be in a range from about 0.005 Ωcm to about 0.035 Ωcm. The thickness of the substrate 110 may be in a range from about 10 µm to about 700 µm. The material, doping type, doping concentration, resistivity, thickness, and the like of the substrate 110 are not limited thereto, and may be variously changed. The substrate 110 may have the first surface 110a and the second surface 110b facing each other. The first surface 110a of the substrate 110 may be the upper surface of the substrate 110, and the second surface 110b of the substrate 110 may be the lower surface of the substrate 110.

In some example embodiments, the substrate 110 may include the active region AR, the termination region TR which is positioned on the outside of the active region AR, and the peripheral region PR which is positioned between the active region AR and the termination region TR. The peripheral region PR may be positioned on the outside of the active region AR. The peripheral region PR may abut the outer edge of the active region AR. The termination region TR may be positioned on the outside of the active region AR and the peripheral region PR. The termination region TR may abut the outer edge of the peripheral region PR. The peripheral region PR and the termination region TR may surround the active region AR in a plan view. In some example embodiments, the peripheral region PR and the termination region TR may have ring shapes in a plan view. In FIG. 1, it is shown that the peripheral region PR and the termination region TR completely surround the active region AR; however, the present disclosure is not limited thereto. The peripheral region PR and the termination region TR may surround a portion of the active region AR.

In some example embodiments, the termination region TR may be positioned on both sides of the active region AR in a first direction DR1, and positioned on both sides of the active region in a second direction DR2, in a plan view; however, the present disclosure is not limited thereto. The termination region TR may be positioned on at least one side of the active region AR in a plan view. The first direction DR1 and the second direction DR2 may be directions parallel with the first surface 110a of the substrate 110. The second direction DR2 may be, for example, a direction orthogonal to the first direction DR1.

The peripheral region PR may be positioned between the active region AR and the termination region TR. In some example embodiments, the peripheral region PR may be positioned on both sides of the active region AR in a first direction DR1 and on both sides of the active region in a second direction DR2, in a plan view; however, the present disclosure is not limited thereto. The peripheral region PR may be positioned in at least a portion between the active region AR and the termination region TR. For example, the termination region TR may be positioned on both sides of the active region AR in the first direction DR1 and on both sides of the active region in the second direction DR2, in a plan view. Alternatively, the peripheral region PR may be positioned only on both sides in the first direction DR1 in a plan view. As another example, the termination region TR may be positioned on both sides of the active region AR in a plan view, and the peripheral region PR may be positioned only on one side of the active region AR in a plan view.

As shown in FIG. 1, for example, the active region AR may be rectangular in a plan view. In some example embodiments, the peripheral region PR and the termination region TR may have rectangular ring shapes in a plan view. However, some example embodiments are not limited thereto, and the planar shapes of the active region AR, the peripheral region PR, and the termination region TR may be variously changed.

The semiconductor layer 131 may be positioned on the first surface 110a of the substrate 110, for example, on the upper surface. The semiconductor layer 131 may be positioned on the entire region of the substrate 110 including the active region AR, the peripheral region PR, and the edge region. The lower surface of the semiconductor layer 131 may abut the upper surface of the substrate 110. However, the present disclosure is not limited thereto, and another desired (and/or alternatively predetermined) layer may be further positioned between the substrate 110 and the semiconductor layer 131. The semiconductor layer 131 may be an epitaxy layer formed on the substrate 110 by epitaxial growth. The semiconductor layer 131 may contain SiC. For example, the semiconductor layer 131 may contain 4H SiC. The semiconductor layer 131 may be doped into the first conductivity type. In some example embodiments, the first conductivity type may be an n-type. The semiconductor layer 131 may be doped into an n-type. The semiconductor layer 131 may be doped into an n-type at a low concentration. The doping concentration of the semiconductor layer 131 may be lower than the doping concentration of the substrate 110.

In some example embodiments, inside the semiconductor layer 131, the doping region 133a, the peripheral doping region 133b, and a termination doping region 133c may be positioned. The doping region 133a, the peripheral doping region 133b, and the termination doping region 133c may be positioned in the upper portion of the semiconductor layer 131. The doping region 133a, the peripheral doping region 133b, and the termination doping region 133c may extend from the upper surface of the semiconductor layer 131 toward the lower surface of the semiconductor layer 131. For example, the doping region 133a, the peripheral doping region 133b, and the termination doping region 133c may extend in a third direction DR3 from the upper surface of the semiconductor layer 131. The doping region 133a, the peripheral doping region 133b, and the termination doping region 133c may be formed in at least some regions of the semiconductor layer 131 by an ion implantation method. The doping region 133a, the peripheral doping region 133b, and the termination doping region 133c may contain SiC. For example, the doping region 133a, the peripheral doping region 133b, and the termination doping region 133c may contain 4H SiC. The doping region 133a, the peripheral doping region 133b, and the termination doping region 133c may be doped into the second conductivity type. In some example embodiments, the second conductivity type may be a p-type. The doping region 133a, the peripheral doping region 133b, and the termination doping region 133c may be doped into a p-type. The doping concentration of the termination doping region 133c may be lower than the doping concentrations of the doping region 133a and the peripheral doping region 133b.

The materials, doping types, and so on of the semiconductor layer 131, the doping region 133a, the peripheral doping region 133b, and the termination doping region 133c are not limited to the above description, and may be variously changed.

In some example embodiments, the doping region 133a may be positioned in the active region AR. In the active region AR, a plurality of doping regions 133a may be positioned. The plurality of doping regions 133a may be disposed so as to be spaced apart in the first direction DR1. Each of the plurality of doping regions 133a may extend in the second direction DR2.

In some example embodiments, in the active region AR, a diode may be positioned. The diode of the semiconductor device according to the some example embodiments may be a SiC diode. The SiC diode which is positioned in the active region AR of the semiconductor device according to some example embodiments may include a Schottky barrier diode and a junction barrier Schottky diode, but is not limited thereto. The Schottky barrier diode may include a structure in which a metal and a semiconductor are bonded. For example, by a structure in which the first electrode 173 and the semiconductor layer 131 are bonded, a Schottky barrier diode may be formed. The junction barrier Schottky diode may be a structure in which a metal and a semiconductor are bonded and which additionally includes a structure in which a p-type semiconductor and an n-type semiconductor are bonded. For example, by a structure in which the first electrode 173 and the doping region 133a are bonded and a structure in which the doping region 133a of the second conductivity type and the semiconductor layer 131 of the first conductivity type are bonded, a junction barrier Schottky diode may be formed.

In some example embodiments, the peripheral doping region 133b may be positioned in the peripheral region PR. The width of the peripheral doping region 133b may be larger than the width of the doping region 133a. The width of the peripheral doping region 133b may be larger than the width of the doping region 133a. The width of the peripheral doping region 133b in the first direction DR1 on a cross section along the first direction DR1 and the third direction DR3 may be larger than the width of the doping region 133a in the first direction DR1. The width of the peripheral doping region 133b in the second direction DR2 on a cross section along the second direction DR2 and the third direction DR3 may be larger than the width of the doping region 133a in the first direction DR1. The peripheral doping region 133b may surround the doping region 133a in a plan view. In some example embodiments, the peripheral doping region 133b may have a ring shape in a plan view. As shown in FIG. 1, the peripheral doping region 133b may have a rectangular ring shape in a plan view; however, the present disclosure is not limited thereto.

In some example embodiments, the termination doping region 133c may be positioned in the termination region TR. Although not shown in the drawing, the termination doping region 133c may surround the peripheral doping region 133b in a plan view. In some example embodiments, the termination doping region 133c may have a ring shape in a plan view. For example, the termination doping region 133c may have a rectangular ring shape in a plan view. The termination doping region 133c may abut the peripheral doping region 133b. The termination doping region 133c may abut the outer surface of the peripheral doping region 133b, but is not limited thereto. For example, the termination doping region 133c may further abut the lower surface of the peripheral doping region 133b. For example, the termination doping region 133c may be formed deeper than the peripheral doping region 133b so as to surround the lower surface of the peripheral doping region 133b.

In FIGS. 2 to 4, a single termination doping region 133c is shown; however, the present disclosure is not limited thereto. In the termination region TR, a plurality of termination doping regions 133c may be disposed so as to be spaced apart in a direction parallel with the first surface 110a of the substrate 110. For example, the plurality of termination doping regions 133c may be disposed so as to be spaced apart in the first direction DR1 and the second direction DR2. Each of the plurality of termination doping regions 133c may have a ring shape. The plurality of termination doping regions 133c may have the same center and be different in the distances from the center.

In some example embodiments, the ohmic contact layer 150 may be positioned in the peripheral region PR. The ohmic contact layer 150 may be positioned on the peripheral doping region 133b. The ohmic contact layer 150 may overlap the peripheral doping region 133b in the third direction DR3. The third direction DR3 may be a direction perpendicular to the first direction DR1 and the second direction DR2 and perpendicular to the first surface 110a of the substrate 110. The width of the ohmic contact layer 150 may be narrower than the width of the peripheral doping region 133b. For example, the width of the ohmic contact layer 150 in the first direction DR1 may be narrower than the width of the peripheral doping region 133b in the first direction DR1. For example, the width of the ohmic contact layer 150 in the second direction DR2 may be narrower than the width of the peripheral doping region 133b in the second direction DR2.

In some example embodiments, the ohmic contact layer 150 may form an ohmic contact between a metal and a semiconductor. The ohmic contact layer 150 may lower the resistance between the metal and the semiconductor. In some example embodiments, the ohmic contact layer 150 may be formed on a structure in which a p-type semiconductor and an n-type semiconductor are bonded. The ohmic contact layer 150 may be positioned on the structure in which the semiconductor layer 131 of the first conductivity type and the peripheral doping region 133b of the second conductivity type are bonded.

In some example embodiments, the ohmic contact layer 150 may be positioned between the peripheral doping region 133b and the first electrode 173. The first electrode 173 may be spaced apart from the peripheral doping region 133b by the ohmic contact layer 150. The ohmic contact layer 150 may be connected to the SiC diode positioned in the active region AR by the first electrode 173. The ohmic contact layer 150 may relieve high-current stress which is applied to the SiC diode positioned in the active region AR when a surge voltage is applied to the SiC diode.

In some example embodiments, the ohmic contact layer 150 may contain a metal silicide material. For example, the ohmic contact layer 150 may contain NiSi, CoSi₂, WSi₂, RuSi, MoSi₂, or TiSi₂, but is not limited thereto. The metal silicide material which is contained in the ohmic contact layer 150 may be variously changed. In some example embodiments, the work function difference between the material of the ohmic contact layer 150 and the material of the peripheral doping region 133b may be smaller than the work function difference between the material of the first electrode 173 and the material of the peripheral doping region 133b. The ohmic contact layer 150 may contain a metal silicide material having a smaller work function difference from the peripheral doping region 133b than the material of the first electrode 173.

In some example embodiments, the ohmic contact layer 150 may be formed by depositing a metal layer so as to cover the upper surface of the peripheral doping region 133b, silicidizing the portion of the metal layer abutting the peripheral doping region 133b through annealing, and removing the portion of the metal layer not silicidized. The lower surface of the ohmic contact layer 150 may be positioned at a lower level than the upper surface of the peripheral doping region 133b. The lower portion of the ohmic contact layer 150 may have a shape buried in the upper surface of the peripheral doping region 133b. The lower portion of the ohmic contact layer 150 may be surrounded by the peripheral doping region 133b. The upper surface of the ohmic contact layer 150 may be positioned at a higher level than the upper surface of the peripheral doping region 133b. The upper portion of the ohmic contact layer 150 may have a shape protruding from the upper surface of the peripheral doping region 133b. The upper portion of the ohmic contact layer 150 may be surrounded by the first electrode 173.

In some example embodiments, the ohmic contact layer 150 may be positioned between the first insulating pattern 141 and a second insulating pattern 142. One side surface of the ohmic contact layer 150 may abut the first insulating pattern 141. For example, the inner surface (e.g., an inner side surface along the first direction DR1) of the ohmic contact layer 150 may abut the first insulating pattern 141. The other side surface of the ohmic contact layer 150 may abut the second insulating pattern 142. For example, the outer surface of the ohmic contact layer 150 may abut the second insulating pattern 142.

In some example embodiments, the first insulating pattern 141 may be positioned in the peripheral region PR. In the peripheral region PR, the first insulating pattern 141 may be positioned on the inner side of the ohmic contact layer 150. The inner side of the ohmic contact layer 150 may refer to a region closer to the active region AR than the ohmic contact layer 150. The first insulating pattern 141 may be positioned on the peripheral doping region 133b and the semiconductor layer 131. A portion of the first insulating pattern 141 may cover the upper surface of the peripheral doping region 133b, and another portion of the first insulating pattern 141 may cover the upper surface of the semiconductor layer 131. The first insulating pattern 141 may overlap a portion of the peripheral doping region 133b in the third direction DR3. The first insulating pattern 141 may overlap a portion of the peripheral doping region 133b, adjacent to the active region AR, in the third direction DR3. The first insulating pattern 141 may abut the peripheral doping region 133b and the semiconductor layer 131. The lower surface of the first insulating pattern 141 may abut the upper surface of the peripheral doping region 133b and the upper surface of the semiconductor layer 131.

In some example embodiments, the first insulating pattern 141 may be positioned between the ohmic contact layer 150 and the first electrode 173. The first insulating pattern 141 may be positioned so as to be adjacent to the ohmic contact layer 150 in a direction parallel with the first surface 110a of the substrate 110. The first insulating pattern 141 may abut the ohmic contact layer 150 in the direction parallel with the first surface 110a. One side surface of the first insulating pattern 141 may abut the ohmic contact layer 150, and the other side surface of the first insulating pattern 141 may abut the first electrode 173. A portion of the outer surface of the first insulating pattern 141 may abut the ohmic contact layer 150, and the other portion of the outer surface of the first insulating pattern 141 and the inner surface and upper surface of the first insulating pattern may abut the first electrode 173. The ohmic contact layer 150 may be spaced apart from a portion of the first electrode 173, positioned in the active region AR, by the first insulating pattern 141. In some example embodiments, the ohmic contact layer 150 may be spaced apart from the portion of the first electrode 173 positioned in the active region AR, in the direction (e.g., the first direction DR1 and the second direction DR2) parallel with the first surface 110a of the substrate 110. This does not mean that the ohmic contact layer 150 is not connected to the portion of the first electrode 173 positioned in the active region AR. The portion of the first electrode 173 positioned in the active region AR may be connected to the portion of the first electrode 173 abutting the ohmic contact layer 150 in the peripheral region PR, on the upper surface of the first insulating pattern 141.

In some example embodiments, the upper surface of the first insulating pattern 141 may be positioned at a higher level than the upper surface of the ohmic contact layer 150. One side surface of the first insulating pattern 141 may abut the ohmic contact layer 150 and the first electrode 173, and the other side surface of the first insulating pattern 141 may entirely abut the first electrode 173.

In some example embodiments, the first electrode 173 may be positioned on the upper surface of the first insulating pattern 141. The upper surface of the first insulating pattern 141 may be covered by the first electrode 173. The upper surface of the first insulating pattern 141 may abut the first electrode 173.

In some example embodiments, the first insulating pattern 141 may extend in a direction parallel with the first surface 110a of the substrate 110. The first insulating pattern 141 may extend in the direction parallel with the first surface 110a along the inner surface of the ohmic contact layer 150. The first insulating pattern 141 may cover the inner surface of the ohmic contact layer 150. The inner surface of the ohmic contact layer 150 may refer to the side surface adjacent to the active region AR. As the ohmic contact layer 150 has a ring shape in a plan view, the first insulating pattern 141 may have a ring shape in a plan view.

In some example embodiments, the second insulating pattern 142 may be positioned in the peripheral region PR and the termination region TR. In the peripheral region PR, the second insulating pattern 142 may be positioned on the outside of the ohmic contact layer 150. The outside of the ohmic contact layer 150 may refer to a region closer to the termination region TR than the ohmic contact layer 150. The second insulating pattern 142 may be positioned on the peripheral doping region 133b, the termination doping region 133c, and the semiconductor layer 131. A portion of the second insulating pattern 142 may cover the upper surface of the peripheral doping region 133b, another portion of the second insulating pattern 142 may cover the upper surface of the termination doping region 133c, and another portion of the second insulating pattern 142 may cover the upper surface of the semiconductor layer 131. The second insulating pattern 142 may overlap a portion of the peripheral doping region 133b in the third direction DR3. The second insulating pattern 142 may overlap a portion of the peripheral doping region 133b, adjacent to the termination region TR, in the third direction DR3. The second insulating pattern 142 may abut the peripheral doping region 133b, the termination doping region 133c, and the semiconductor layer 131. The lower surface of the second insulating pattern 142 may abut the upper surface of the peripheral doping region 133b, the upper surface of the termination doping region 133c, and the upper surface of the semiconductor layer 131.

In some example embodiments, the second insulating pattern 142 may be positioned on the outer surface of the ohmic contact layer 150. The second insulating pattern 142 may cover the outer surface of the ohmic contact layer 150. The outer surface of the ohmic contact layer 150 may refer to the side surface adjacent to the termination region TR.

In some example embodiments, the second insulating pattern 142 may extend in a direction parallel with the first surface 110a of the substrate 110. The second insulating pattern 142 may extend in the direction parallel with the first surface 110a along the outer surface of the ohmic contact layer 150. As the ohmic contact layer 150 has a ring shape in a plan view, the second insulating pattern 142 may have a ring shape in a plan view.

In some example embodiments, the upper surface of the second insulating pattern 142 may be positioned at a higher level than the upper surface of the ohmic contact layer 150. One side surface of the second insulating pattern 142 may abut the ohmic contact layer 150 and the first electrode 173. The upper surface of the second insulating pattern 142 may be positioned at the same level or at substantially the same level as that of the upper surface of the first insulating pattern 141. Between the first insulating pattern 141 and the second insulating pattern 142, the ohmic contact layer 150 and the first electrode 173 may be positioned.

In some example embodiments, the first insulating pattern 141 and the second insulating pattern 142 may be isolated; however, the present disclosure is not limited thereto. In some example embodiments, the first insulating pattern 141 and the second insulating pattern 142 may be connected. The first insulating pattern 141 and the second insulating pattern 142 may be formed by performing patterning on an insulating layer formed so as to cover the semiconductor layer 131, the doping region 133a, the peripheral doping region 133b, and the termination doping region 133c. The first insulating pattern 141 and the second insulating pattern 142 may be insulating patterns which expose at least a portion of the upper surface of the peripheral doping region 133b in order to form the ohmic contact layer 150 on the peripheral doping region 133b, which is positioned in the peripheral region PR. The first insulating pattern 141 and the second insulating pattern 142 may be insulating patterns which expose at least some portions of the upper surfaces of the doping region 133a and the semiconductor layer 131 in order to form the first electrode 173 which abuts the doping region 133a and the semiconductor layer 131 positioned in the active region AR.

The first insulating pattern 141 and the second insulating pattern 142 may contain an insulating material. In some example embodiments, the first insulating pattern 141 and the second insulating pattern 142 may contain at least one of silicon oxides, silicon nitrides, and silicon oxynitrides; however, the present disclosure is not limited thereto. The insulating material which is contained in the first insulating pattern 141 and the second insulating pattern 142 may be variously changed.

In some example embodiments, the first electrode 173 may be positioned on the semiconductor layer 131, the doping region 133a, and the peripheral doping region 133b. The first electrode 173 may be positioned in the active region AR and the peripheral region PR. The first electrode 173 may not be positioned in the termination region TR. The first electrode 173 may be positioned on the semiconductor layer 131 and the doping region 133a in the active region AR. The first electrode 173 may be positioned on the semiconductor layer 131 and the peripheral doping region 133b in the peripheral region PR. In the active region AR, the first electrode 173 may overlap the semiconductor layer 131 and the doping region 133a in the third direction DR3. In the peripheral region PR, the first electrode 173 may overlap the semiconductor layer 131 and the peripheral doping region 133b in the third direction DR3.

In some example embodiments, the first electrode 173 may abut the semiconductor layer 131 and the doping region 133a. The first electrode 173 may abut the upper surface of the semiconductor layer 131 and the upper surface of the doping region 133a. As the lower surface of the first electrode 173 abuts the upper surface of the semiconductor layer 131, a Schottky barrier diode may be formed. As the lower surface of the first electrode 173 abuts the upper surface of the doping region 133a, a junction barrier Schottky diode may be formed.

In some example embodiments, the first electrode 173 may not abut the peripheral doping region 133b. The first electrode 173 may be spaced apart from the upper surface of the peripheral doping region 133b by the ohmic contact layer 150. Between the first electrode 173 and the peripheral doping region 133b, the ohmic contact layer 150 may be positioned.

In some example embodiments, the first electrode 173 may cover the first insulating pattern 141. The first electrode 173 may cover the upper surface and both side surfaces of the first insulating pattern 141. The first electrode 173 may cover the second insulating pattern 142. In some example embodiments, the first electrode 173 may cover the upper surface and side surface of the second insulating pattern 142. The first electrode 173 may cover a portion of the upper surface of the second insulating pattern 142. The first electrode 173 may cover a portion of the upper surface of the second insulating pattern 142 overlapping the peripheral doping region 133b in the third direction DR3. The upper surface of the first electrode 173 may be positioned at a higher level than the upper surface of the first insulating pattern 141 and the upper surface of the second insulating pattern 142.

In some example embodiments, the portion of the first electrode 173 positioned in the active region AR and the portion of the first electrode 173 positioned in the peripheral region PR may be connected on the upper surface of the first insulating pattern 141. The portion of the first electrode 173 which abuts the semiconductor layer 131 and the doping region 133a in the active region AR and the portion of the first electrode 173 which abuts the ohmic contact layer 150 in the peripheral region PR may be connected on the upper surface of the first insulating pattern 141. The portion of the first electrode 173 which is positioned on the inner surface of the first insulating pattern 141 and the portion of the first electrode 173 which is positioned on the outer surface of the first insulating pattern 141 may be connected on the upper surface of the first insulating pattern 141. The inner surface of the first insulating pattern 141 may be the side surface adjacent to the active region AR, and the outer surface of the first insulating pattern 141 may be the side surface adjacent to the termination region TR.

In some example embodiments, the first electrode 173 may have a plate shape entirely covering at least some portions of the active region AR and the peripheral region PR adjacent to the active region AR. The planar shape of the first electrode 173 may be, for example, a rectangle, but is not limited thereto, and the planar shape of the first electrode 173 may be variously changed.

The first electrode 173 may contain a conductive material. For example, the first electrode 173 may contain a metal, a metal alloy, a conductive metal nitride, a metal silicide material, a conductive metal oxide, a conductive metal nitride, or the like. The first electrode 173 may contain, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAIC-N), titanium aluminum carbide (TiAlC), titanium carbide (TiC), tantalum carbonizationnitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. In FIGS. 2 to 4, it is shown that the first electrode 173 is a single layer; however, the present disclosure is not limited thereto. The first electrode 173 may consist of multiple layers.

The second electrode 175 may be positioned on the second surface 110b of the substrate 110, e.g., the lower surface. The upper surface of the second electrode 175 may abut the lower surface of the substrate 110. The second electrode 175 may be in ohmic contact with the substrate 110. The region inside the substrate 110 which is in contact with the second electrode 175 may be doped at a relatively higher concentration, as compared to the other region. However, the present disclosure is not limited thereto, and between the second electrode 175 and the substrate 110, another desired (and/or alternatively predetermined) layer may be further positioned. For example, between the second electrode 175 and the substrate 110, a silicide layer may be positioned. The silicide layer may contain a metal silicide material. By the metal silicide layer, the second electrode 175 and the substrate 110 may be electrically smoothly connected.

The second electrode 175 may contain a conductive material. For example, the second electrode 175 may contain a metal, a metal alloy, a conductive metal nitride, a metal silicide material, a doped semiconductor material, a conductive metal oxide, a conductive metal oxynitride, or the like. The second electrode 175 may consist of the same material as that of the first electrode 173, or may consist of a material different from that of the first electrode. The second electrode 175 may consist of a single layer or multiple layers.

The semiconductor device according to some example embodiments may include the ohmic contact layer 150 that contains the metal silicide material between the peripheral doping region 133b, which is positioned in the peripheral region PR positioned between the active region AR and the termination region TR positioned on the outside of the active region AR, and the first electrode 173 which abuts the doping region 133a and the semiconductor layer 131 positioned in the active region AR, and the first insulating pattern 141 that extends in the direction parallel with the first surface 110a of the substrate 110 between the ohmic contact layer 150 and the first electrode 173. According to the some example embodiments, it is possible to protect the semiconductor device from a surge voltage.

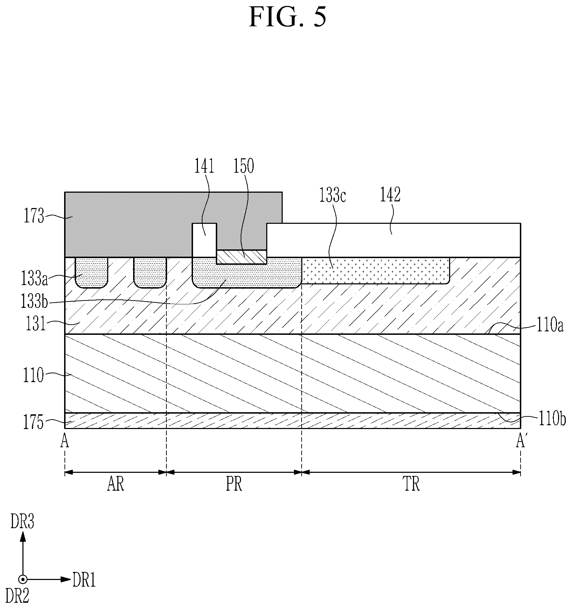

Hereinafter, a modification of the semiconductor device according to some example embodiments shown in FIGS. 1 to 4 will be described with reference to FIGS. 5 to 7.

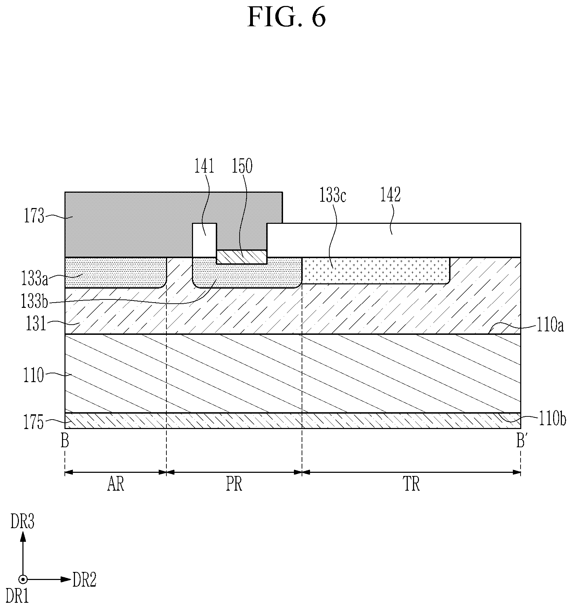

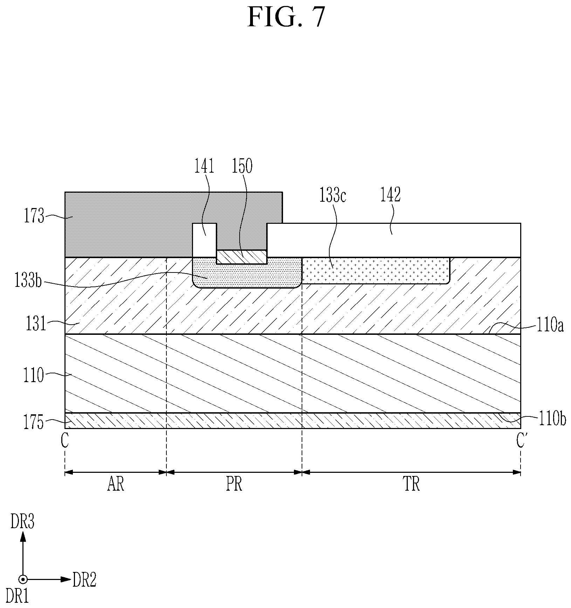

FIG. 5 is a cross-sectional view taken along line A-A' of FIG. 1. FIG. 6 is a cross-sectional view taken along line B-B' of FIG. 1. FIG. 7 is a cross-sectional view taken along line C-C' of FIG. 1. Since some example embodiments shown in FIGS. 5 to 7 have many portions identical to those of the some example embodiments shown in FIGS. 1 to 4, description thereof will not be made and the differences will be mainly described. Also, constituent elements identical to those of the above some example embodiments are denoted by the same reference symbols. Some example embodiments shown in FIGS. 5 to 7 may be partially different than some example embodiments shown in FIGS. 1 to 4 in the structure of the first insulating pattern 141.

Referring to FIGS. 5 to 7, the first insulating pattern 141 may be positioned in the peripheral region PR. In some example embodiments shown in FIGS. 5 to 7, in the peripheral region PR, the first insulating pattern 141 may abut the peripheral doping region 133b and may not abut the semiconductor layer 131, unlike in some example embodiments shown in FIGS. 1 to 4. The first insulating pattern 141 may not be positioned on the upper surface of the semiconductor layer 131 positioned between the doping region 133a and the peripheral doping region 133b. In some example embodiments shown in FIGS. 1 to 4, the upper surface of the semiconductor layer 131 positioned between the doping region 133a and the peripheral doping region 133b is covered by the first insulating pattern 141, but in some example embodiments shown in FIGS. 5 to 7, the upper surface of the semiconductor layer 131 positioned between the doping region 133a and the peripheral doping region 133b may not be covered by the first insulating pattern 141.

In some example embodiments, the first electrode 173 may abut the semiconductor layer 131 in the peripheral region PR. The first electrode 173 may abut the semiconductor layer 131 positioned between the doping region 133a and the peripheral doping region 133b.

When the first insulating pattern 141 is patterned in order to expose the upper surfaces of the semiconductor layer 131 and the doping region 133a positioned in the active region AR, the portion of the first insulating pattern 141 covering the upper surface of the semiconductor layer 131 positioned between the doping region 133a and the peripheral doping region 133b may be removed, whereby the first insulating pattern 141 according to some example embodiments shown in FIGS. 5 to 7 may be formed.

The width of the first insulating pattern 141 according to some example embodiments shown in FIGS. 5 to 7 may be narrower than the width of the first insulating pattern 141 according to some example embodiments shown in FIGS. 1 to 4. Here, the width of the first insulating pattern 141 may refer to the width in a direction (e.g., the first direction DR1 and the second direction DR2) parallel with the first surface 110a of the substrate 110.

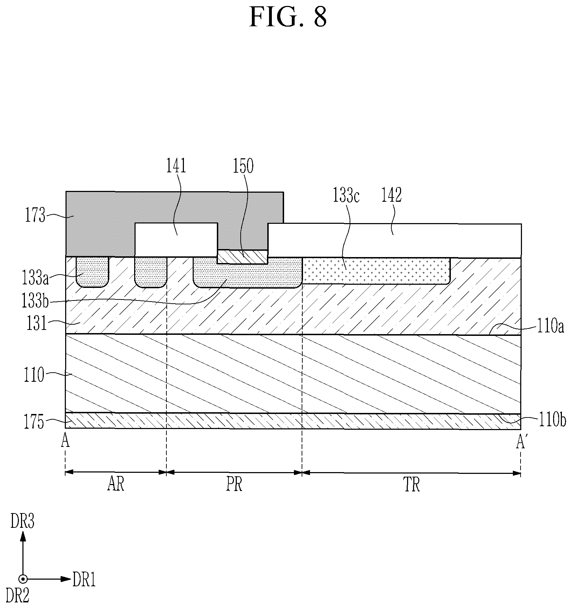

Hereinafter, a modification of the semiconductor device according to some example embodiments shown in FIGS. 1 to 4 will be described with reference to FIGS. 8 to 10.

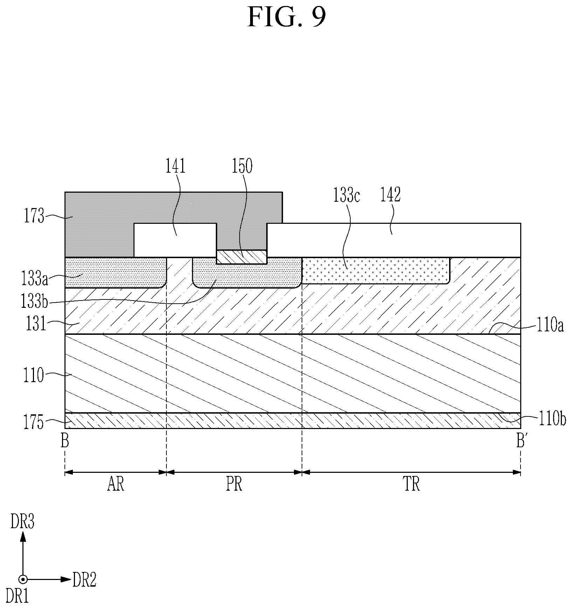

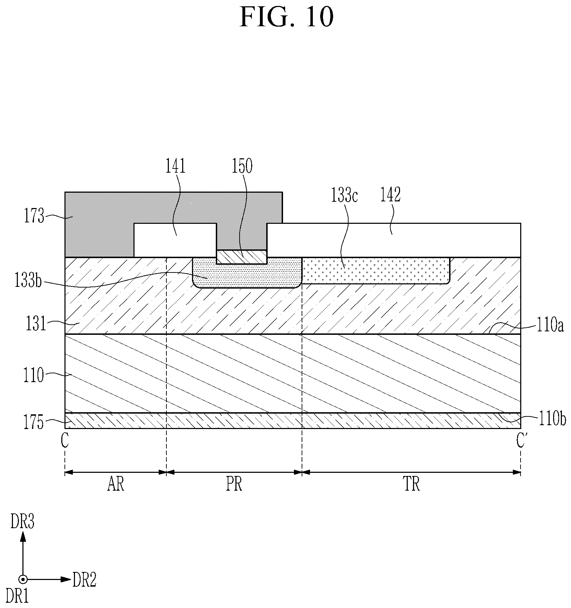

FIG. 8 is a cross-sectional view taken along line A-A' of FIG. 1. FIG. 9 is a cross-sectional view taken along line B-B' of FIG. 1. FIG. 10 is a cross-sectional view taken along line C-C' of FIG. 1. Since some example embodiments shown in FIGS. 8 to 10 have many portions identical to those of some example embodiments shown in FIGS. 1 to 4, description thereof will not be made and the differences will be mainly described. Also, constituent elements identical to those of the above some example embodiments are denoted by the same reference symbols. Some example embodiments shown in FIGS. 8 to 10 may be partially different from some example embodiments shown in FIGS. 1 to 4 in the structure of the first insulating pattern 141.

Referring to FIGS. 8 to 10, the first insulating pattern 141 may be positioned in the active region AR and the peripheral region PR. In some example embodiments shown in FIGS. 8 to 10, a portion of the first insulating pattern 141 may be positioned in the active region AR, and another portion of the first insulating pattern 141 may be positioned in the peripheral region PR, unlike in some example embodiments shown in FIGS. 1 to 4. The first insulating pattern 141 may be positioned on the doping region 133a positioned inside the active region AR1. The first insulating pattern 141 may be positioned on the doping region 133a adjacent to the peripheral region PR. The first insulating pattern 141 may cover the upper surface of the doping region 133a adjacent to the peripheral region PR. Since the doping region 133a which is covered by the first insulating pattern 141 does not abut the first electrode 173, it does not constitute a junction barrier Schottky diode.

In FIGS. 8 to 10, it is shown that the first insulating pattern 141 covers only the upper surface of the doping region 133a; however, the present disclosure is not limited thereto, and the first insulating pattern 141 may further cover the upper surface of the semiconductor layer 131 adjacent to the doping region 133a. In FIGS. 8 to 10, it is shown that the first insulating pattern 141 covers only the upper surface of one doping region 133a closest to the peripheral region PR; however, the present disclosure is not limited thereto, and the first insulating pattern may cover the upper surfaces of a plurality of doping regions 133a adjacent to the peripheral region PR and the upper surface of the semiconductor layer 131 between the plurality of doping regions 133a.

When the first insulating pattern 141 is patterned in order to expose the upper surfaces of the semiconductor layer 131 and the doping region 133a positioned in the active region AR, less of the portion of the first insulating pattern 141 covering the upper surface of the doping region 133a adjacent to the peripheral region PR may be removed, whereby the first insulating pattern 141 according to some example embodiments shown in FIGS. 8 to 10 may be formed.

The width of the first insulating pattern 141 according to some example embodiments shown in FIGS. 8 to 10 may be wider than the width of the first insulating pattern 141 according to some example embodiments shown in FIGS. 1 to 4. Here, the width of the first insulating pattern 141 may refer to the width in a direction (e.g., the first direction DR1 and the second direction DR2) parallel with the first surface 110a of the substrate 110.

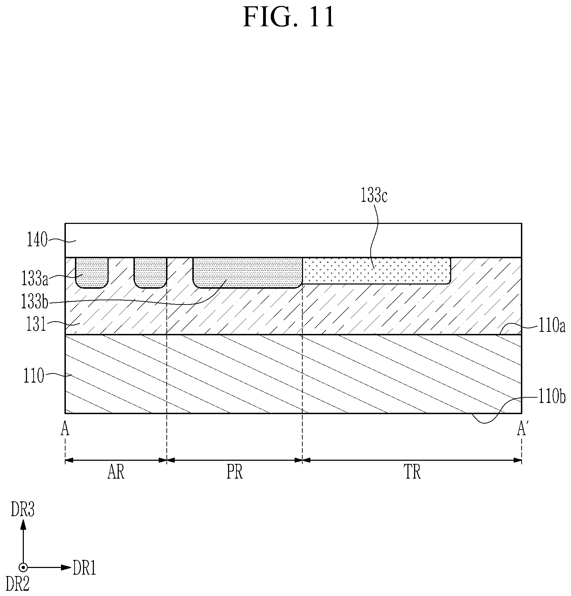

Hereinafter, a method of manufacturing the semiconductor device according to some example embodiments shown in FIGS. 1 to 4 will be described with reference to FIGS. 11 to 20.

FIGS. 11 to 20 are cross-sectional views illustrating processes of manufacturing a semiconductor device according to some example embodiments in the order of the processes.

Referring to FIG. 11, on the first surface 110a of the substrate 110, the semiconductor layer 131 of the first conductivity type may be formed, and in the upper portion of the semiconductor layer 131, the doping region 133a of the second conductivity type and the peripheral doping region 133b of the second conductivity type may be formed.

The substrate 110 may be a semiconductor substrate containing SiC. For example, the substrate 110 may consist of a 4H SiC substrate. The substrate 110 may be doped into the first conductivity type. For example, the first conductivity type may be an n-type. The substrate 110 may be doped into an n-type. The substrate 110 may be doped into an n-type at a high concentration. The first surface 110a of the substrate 110 may be the upper surface, and the second surface 110b of the substrate 110 may be the lower surface.

In some example embodiments, the substrate 110 may include the active region AR, the termination region TR which is positioned on the outside of the active region AR, and the peripheral region PR which is positioned between the active region AR and the termination region TR. The peripheral region PR may be positioned on the outside of the active region AR. The termination region TR may be positioned on the outside of the active region AR and the peripheral region PR. The peripheral region PR and the termination region TR may surround the active region AR in a plan view. However, the peripheral region PR and the termination region TR are not limited to completely surrounding the active region AR, and the peripheral region PR and the termination region TR may surround a portion of the active region AR.

In some example embodiments, the peripheral region PR and the termination region TR may have ring shapes in a plan view. For example, the active region AR may be rectangular in a plan view. In some example embodiments, the peripheral region PR and the termination region TR may have rectangular ring shapes in a plan view. However, the some example embodiments is not limited to, and the planar shapes of the active region AR, the peripheral region PR, and the termination region TR may be variously changed.

On the first surface 110a of the substrate 110, e.g., on the upper surface, the semiconductor layer 131 of the first conductivity type may be formed by epitaxial growth. The semiconductor layer 131 may be formed directly on the substrate 110, or after another desired (and/or alternatively predetermined) layer is formed on the substrate 110, the semiconductor layer 131 may be formed thereon. The semiconductor layer 131 may contain SiC. For example, the semiconductor layer 131 may contain 4H SiC. The semiconductor layer 131 may be doped into the first conductivity type. For example, the first conductivity type may be an n-type. The semiconductor layer 131 may be doped into an n-type. The semiconductor layer 131 may be doped into an n-type at a low concentration. The doping concentration of the semiconductor layer 131 may be lower than the doping concentration of the substrate 110. The dopant material for the semiconductor layer 131 may be the same as the dopant material for the substrate 110, or may be different from the dopant material for the substrate.

Next, in the upper portion of the semiconductor layer 131 positioned in the active region AR, the doping region 133a of the second conductivity type may be formed, and in the upper portion of the semiconductor layer 131 positioned in the peripheral region PR, the peripheral doping region 133b of the second conductivity type may be formed. Further, in the upper portion of the semiconductor layer 131 positioned in the termination region TR, the termination doping region 133c of the second conductivity type may be formed. The doping region 133a, the peripheral doping region 133b, and the termination doping region 133c may be formed by an ion implantation process (IIP). First, regions where the doping region 133a, the peripheral doping region 133b, and the termination doping region 133c will be formed may be defined on the semiconductor layer 131 by a photolithography process. Thereafter, impurities of the second conductivity type may be implanted into the corresponding regions. The doping region 133a, the peripheral doping region 133b, and the termination doping region 133c may have desired (and/or alternatively predetermined) depths. In some example embodiments, the depths of the doping region 133a, the peripheral doping region 133b, and the termination doping region 133c may be determined by the numbers (e.g., amount) of impurities which are implanted, and/or the rates at which the impurities are accelerated.

In some example embodiments, a plurality of doping regions 133a may be formed in the active region AR. The plurality of doping regions 133a may be formed so as to be spaced apart in the first direction DR1, and each of the plurality of doping regions 133a may extend in the second direction DR2.

In some example embodiments, the peripheral doping region 133b which is formed in the peripheral region PR may have a ring shape surrounding the plurality of doping regions 133a in a plan view. For example, the peripheral doping region 133b may have a rectangular ring shape in a plan view. The width of the peripheral doping region 133b may be larger than the width of the doping region 133a. The width of the peripheral doping region 133b in the first direction DR1 on a cross section along the first direction DR1 and the third direction DR3 may be larger than the width of the doping region 133a in the first direction DR1. The width of the peripheral doping region 133b in the second direction DR2 on a cross section along the second direction DR2 and the third direction DR3 may be larger than the width of the doping region 133a in the first direction DR1.

In the some example embodiments, the termination doping region 133c may be formed so as to abut the outer surface of the peripheral doping region 133b. The termination doping region 133c may have a ring shape surrounding the plurality of doping regions 133a and the peripheral doping region 133b. For example, the termination doping region 133c may have a rectangular ring shape in a plan view. In the termination region TR, a single termination doping region 133c may be formed, or a plurality of termination doping regions 133c may be formed. The plurality of termination doping regions 133c may be disposed so as to be spaced apart in a direction parallel with the first surface 110a of the substrate 110. The plurality of individual termination doping regions 133c may have ring shapes having the same center and different in the distances from the center.

The doping region 133a, the peripheral doping region 133b, and the termination doping region 133c may contain SiC. For example, the doping region 133a, the peripheral doping region 133b, and the termination doping region 133c may contain 4H SiC. The doping region 133a, the peripheral doping region 133b, and the termination doping region 133c may be doped into the second conductivity type. For example, the second conductivity type may be a p-type. The doping region 133a, the peripheral doping region 133b, and the termination doping region 133c may be doped into a p-type.

In some example embodiments, the doping region 133a and the peripheral doping region 133b may be doped into a p-type at a high concentration, and the termination doping region 133c may be doped into a p-type at a low concentration. For example, after the doping region 133a, the peripheral doping region 133b, and the termination doping region 133c are doped into a p-type at a low concentration, the doping region 133a and the peripheral doping region 133b may be additionally doped. As another example, the doping region 133a and the peripheral doping region 133b, and the termination doping region 133c may be doped separately such that the doping region and the peripheral doping region are doped at a concentration different from that of the doping concentration of the termination doping region.

The materials, doping types, and the like of doping region 133a, the peripheral doping region 133b, and the termination doping region 133c are not limited thereto, and may be variously changed.

Next, on the semiconductor layer 131, the doping region 133a, the peripheral doping region 133b, and the termination doping region 133c, an insulating layer 140 may be formed. The insulating layer 140 may be formed through a deposition process such as physical vapor deposition (PVD), chemical vapor deposition (CVD), or atomic layer deposition (ALD). The insulating layer 140 may be formed throughout the active region AR, peripheral region PR, and termination region TR of the substrate 110.

The insulating layer 140 may contain an insulating material. The insulating layer 140 may contain, for example, a silicon oxide, but is not limited thereto. The insulating material which is contained in the insulating layer 140 may be variously changed.

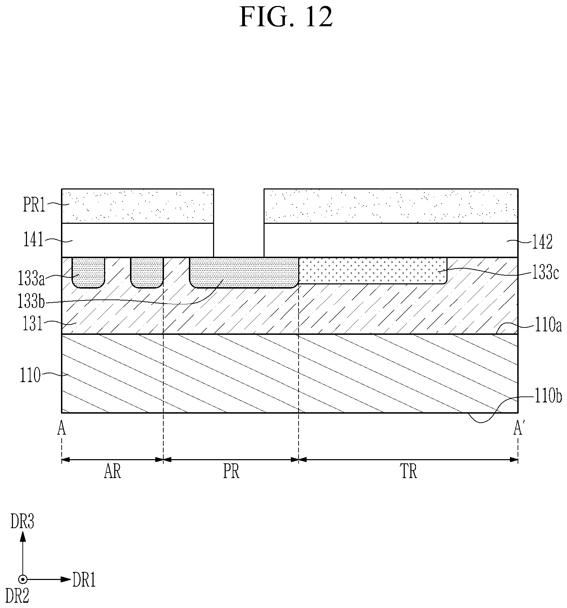

Referring to FIG. 12, on the insulating layer 140, a first photoresist pattern PR1 may be formed, and patterning may be performed on the insulating layer 140 using the first photoresist pattern PR1 to form the first insulating pattern 141 and the second insulating pattern 142.

First, after a first photoresist layer is formed on the insulating layer 140, patterning may be performed on the first photoresist layer through a photolithography process to form the first photoresist pattern PR1. The first photoresist pattern PR1 may be used to perform patterning on the insulating layer 140 by an etching process. The portion of the insulating layer 140 that is not covered by the first photoresist pattern PR1 may be etched and removed. Accordingly, the portion of the upper surface of the peripheral doping region 133b having been covered by the insulating layer 140 may be exposed. The first insulating pattern 141 and the second insulating pattern 142 may be the portions of the insulating layer 140 remaining after performing the etching process. The first insulating pattern 141 and the second insulating pattern 142 may be spaced apart from each other. In a plan view, the second insulating pattern 142 may have a shape surrounding the first insulating pattern 141.

In some example embodiments, the first insulating pattern 141 may cover a portion of the upper surface of the peripheral doping region 133b adjacent to the active region AR, and the second insulating pattern 142 may cover a portion of the upper surface of the peripheral doping region 133b adjacent to the termination region TR. By the opening between the first insulating pattern 141 and the second insulating pattern 142, an approximately central portion of the upper surface of the peripheral doping region 133b may be exposed. In some example embodiments, the exposed portion of the upper surface of the peripheral doping region 133b may have a ring shape narrower than the width of the entire upper surface of the peripheral doping region 133b in a plan view. Here, the width of the upper surface of the peripheral doping region 133b may refer to the width in a direction (e.g., the first direction DR1 or the second direction DR2) parallel with the first surface 110a of the substrate 110.

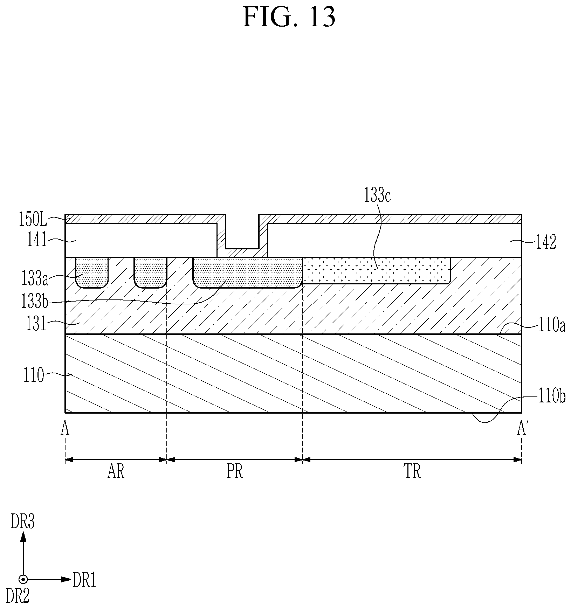

Referring to FIG. 13, the first photoresist pattern PR1 may be removed, and a metal layer 150L may be formed. The metal layer 150L may be formed so as to cover the first insulating pattern 141, the second insulating pattern 142, and the peripheral doping region 133b. The metal layer 150L may cover the upper surface of the peripheral doping region 133b. The metal layer 150L may cover the upper surface of the first insulating pattern 141, the upper surface of the second insulating pattern 142, and the side surfaces of the first insulating pattern 141 and the second insulating pattern 142 facing each other. The metal layer 150L may cover the first insulating pattern 141, the second insulating pattern 142, and the peripheral doping region 133b so as to conform to them.

For example, the metal layer 150L may be formed by a process such as electroplating, sputtering, or CVD; however, the process of forming the metal layer 150L is not limited thereto, and may be variously changed.

The metal layer 150L may contain a metal material. The metal layer 150L may contain, for example, Ni, Co, W, Ru, Mo, or Ti, but is not limited thereto. The material of the metal layer 150L may be variously changed, and needs only to be able to form a metal silicide material at the junction with SiC.

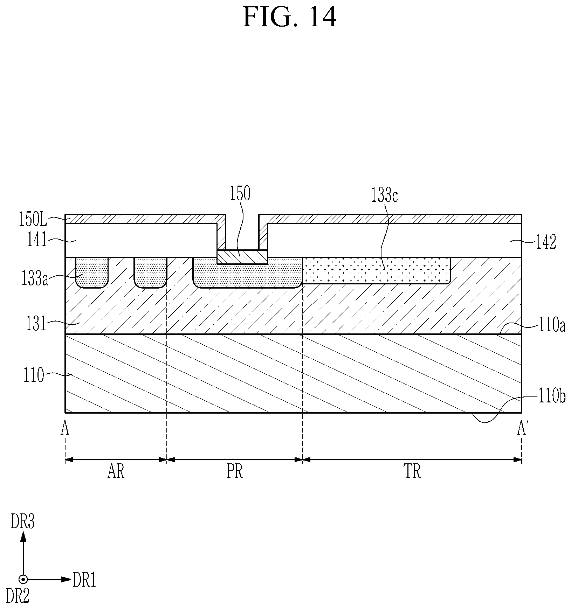

Referring to FIG. 14, the ohmic contact layer 150 may be formed by performing an annealing process.

When the annealing process is performed, the junction of the peripheral doping region 133b and the metal layer 150L may be silicidized. The metal material of the metal layer 150L and SiC of the peripheral doping region 133b may react to form the ohmic contact layer 150 which contains the metal silicide material. The ohmic contact layer 150 may contain, for example, NiSi, CoSi₂, WSi₂, RuSi, MoSi₂, or TiSi₂, but is not limited thereto. The metal silicide material which is contained in the ohmic contact layer 150 may be variously changed. In some example embodiments, the ohmic contact layer 150 may contain a material having a smaller work function difference from the peripheral doping region 133b than the first electrode 173 to be described below.

In some example embodiments, the ohmic contact layer 150 may abut the peripheral doping region 133b. The lower surface of the ohmic contact layer 150 may be positioned at a lower level than the upper surface of the peripheral doping region 133b. The upper surface of the ohmic contact layer 150 may be positioned at a higher level than the upper surface of the peripheral doping region 133b. The width of the ohmic contact layer 150 may be narrower than the width of the peripheral doping region 133b. The width of the ohmic contact layer 150 in the first direction DR1 may be narrower than the width of the peripheral doping region 133b in the first direction DR1. The width of the ohmic contact layer 150 in the second direction DR2 may be narrower than the width of the peripheral doping region 133b in the second direction DR2.

In some example embodiments, one side surface of the ohmic contact layer 150 may abut the peripheral doping region 133b and the first insulating pattern 141. The other side surface of the ohmic contact layer 150 may abut the peripheral doping region 133b and the second insulating pattern 142.

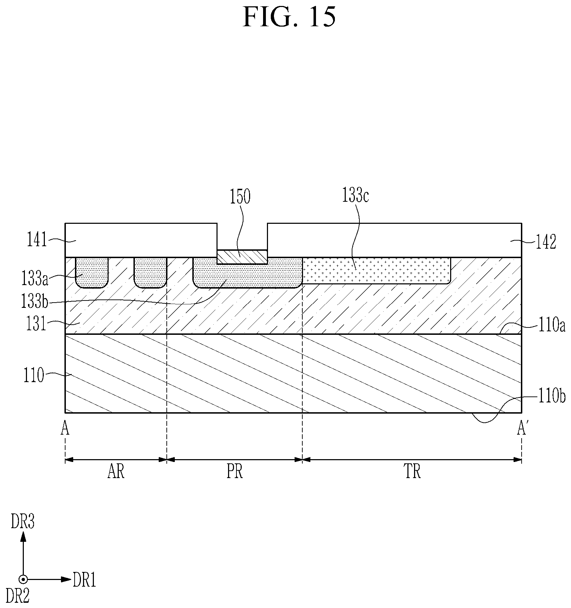

Referring to FIG. 15, the metal layer 150L which has not reacted with SiC may be removed. The metal layer 150L may be removed, for example, through a wet etching process, but is not limited thereto. The process of etching the metal layer 150L may be performed using a material having high etch selectivity to the first insulating pattern 141, the second insulating pattern 142, and the ohmic contact layer 150. The first insulating pattern 141, the second insulating pattern 142, and the ohmic contact layer 150 may be barely etched, and the metal layer 150L may be well etched and removed.

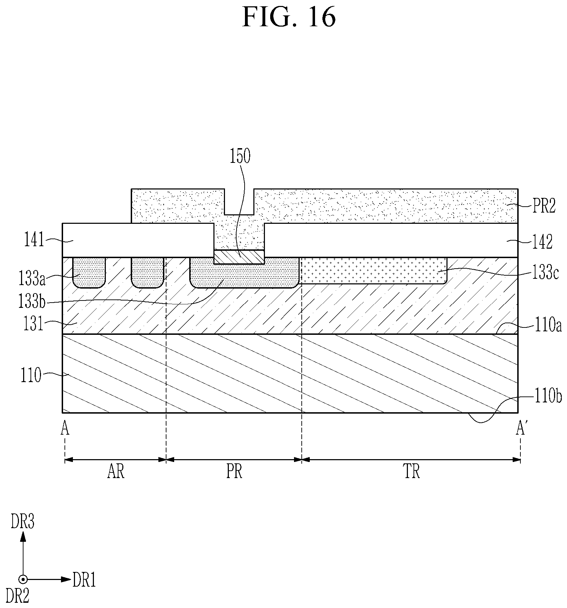

Referring to FIG. 16, on the first insulating pattern 141, the ohmic contact layer 150, and the second insulating pattern 142, a second photoresist pattern PR2 may be formed. For example, after a second photoresist layer is formed on the first insulating pattern 141, the ohmic contact layer 150, and the second insulating pattern 142, patterning may be performed on the second photoresist layer through a photolithography process to form the second photoresist pattern PR2.

In some example embodiments, the second photoresist pattern PR2 may cover the ohmic contact layer 150. The ohmic contact layer 150 can be limited and/or prevented from being etched together with the first insulating pattern 141 by a material which is used in the subsequent etching process of opening the active region AR. Further, the second photoresist pattern PR2 may further cover the first insulating pattern 141 positioned on the inner side of the ohmic contact layer 150. The inner side of the ohmic contact layer 150 may refer to the region adjacent to the active region AR. The first insulating pattern 141 should be covered such that the material which is used in the subsequent etching process cannot etch the ohmic contact layer 150 even if it exerts an effect in a direction parallel with the first surface 110a of the substrate 110. For this reason, the second photoresist pattern PR2 may be patterned so as to cover the portion of the first insulating pattern 141 covering the inner surface of the ohmic contact layer 150.

In some example embodiments, depending on the width by which the second photoresist pattern PR2 covers the first insulating pattern 141 positioned on the inner side of the ohmic contact layer 150, the width and structure of the first insulating pattern 141 which remains in the final structure may vary. According to some example embodiments, the first insulating pattern 141 may be positioned only inside the peripheral region PR. According to some example embodiments, the first insulating pattern may be positioned on the upper surface of the peripheral doping region 133b in the peripheral region PR and the upper surface of the semiconductor layer 131 positioned between the doping region 133a and the peripheral doping region 133b. However, the first insulating pattern is not limited thereto. For example, as shown in FIGS. 5 to 7, in some example embodiments the first insulating pattern 141 may be positioned only on the upper surface of the peripheral doping region 133b in the peripheral region PR, and may not be positioned on the upper surface of the semiconductor layer 131 positioned between the doping region 133a and the peripheral doping region 133b. As another example, in some example embodiments as shown in FIGS. 8 to 10, a portion of the first insulating pattern 141 may be positioned in the active region AR, and another portion of the first insulating pattern 141 may be positioned in the peripheral region PR.

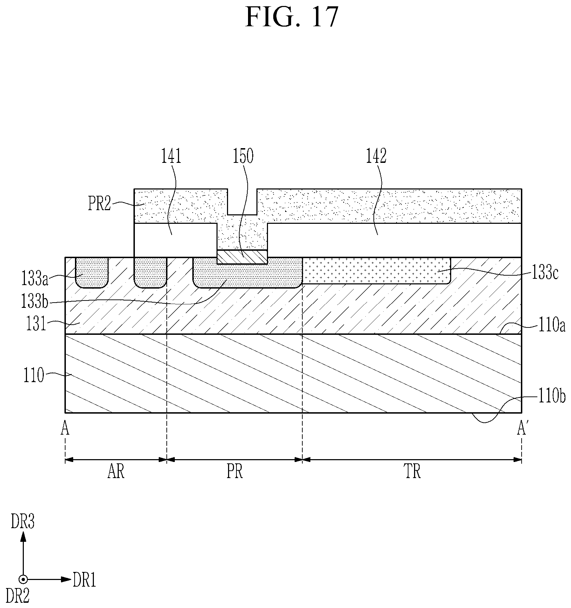

Referring to FIG. 17, a portion of the first insulating pattern 141 may be removed by performing an etching process using the second photoresist pattern PR2. The portion of the first insulating pattern 141 that is not covered by the second photoresist pattern PR2 may be etched and removed. Accordingly, the upper surface of the doping region 133a positioned in the active region AR and the upper surface of the semiconductor layer 131 may be exposed.

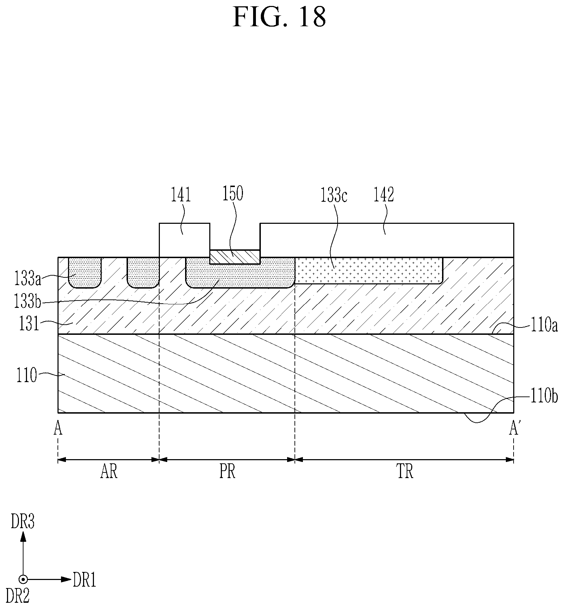

Referring to FIG. 18, the second photoresist pattern PR2 may be removed. For example, the second photoresist pattern PR2 may be removed through an ashing process and/or a strip process. While the second photoresist pattern PR2 is removed, a portion of the first insulating pattern 141 may be removed together. For example, a portion of the first insulating pattern 141 adjacent to an end portion of the second photoresist pattern PR2 may be removed together.

In some example embodiments, the first insulating pattern 141 may overlap a portion of the peripheral doping region 133b in the third direction DR3 perpendicular to the first surface 110a of the substrate 110. The first insulating pattern 141 may abut the portion of the peripheral doping region 133b in the third direction DR3. The lower surface of the first insulating pattern 141 may abut the upper surface of the peripheral doping region 133b positioned on the inner side of the ohmic contact layer 150.

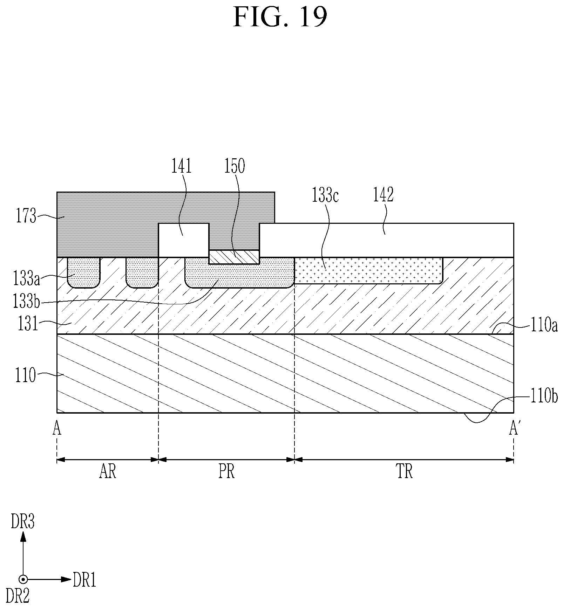

Referring to FIG. 19, the first electrode 173 may be formed so as to abut the doping region 133a, the semiconductor layer 131, and the ohmic contact layer 150. First, a first electrode material layer may be formed so as to cover the upper surfaces of the semiconductor layer 131, the doping region 133a, the first insulating pattern 141, the ohmic contact layer 150, and the second insulating pattern 142, and then, patterning may be performed on the first electrode material layer through a photolithography process and an etching process.

In some example embodiments, the first electrode 173 may be positioned on the active region AR and the peripheral region PR, and may not be positioned in the termination region TR. The first electrode 173 may abut the upper surfaces of the semiconductor layer 131 and the doping region 133a in the active region AR. The first electrode 173 may abut the upper surface of the ohmic contact layer 150 in the peripheral region PR.

In some example embodiments, the first electrode 173 may surround the first insulating pattern 141. The first electrode 173 may cover the upper surface and both side surfaces of the first insulating pattern 141. The first electrode 173 may cover the inner surface of the second insulating pattern 142. The inner surface of the second insulating pattern 142 may be the side surface abutting the ohmic contact layer 150. The first electrode 173 may cover a portion of the upper surface of the second insulating pattern 142, but is not limited thereto. The first electrode 173 may cover only the inner surface of the second insulating pattern 142, and may not cover the upper surface of the second insulating pattern 142.

The first electrode 173 may contain a conductive material. For example, the first electrode 173 may contain a metal, a metal alloy, a conductive metal nitride, a metal silicide material, a conductive metal oxide, a conductive metal nitride, or the like.

As the first electrode 173 and the semiconductor layer 131 abut each other in the active region AR, a Schottky barrier diode may be formed. As the first electrode 173 and the doping region 133a abut each other and the doping region 133a abuts the semiconductor layer 131 of the different conductivity type in the active region AR, a junction barrier Schottky diode may be formed. In the peripheral region PR, the semiconductor layer 131 and the peripheral doping region 133b having different conductivity types may abut each other, and the ohmic contact layer 150 may be positioned between the peripheral doping region 133b and the first electrode 173. The ohmic contact layer 150 may lower the resistance between the first electrode 173 and the peripheral doping region 133b. Accordingly, when a surge voltage is applied to diodes positioned in the active region AR, a portion of high current may flow through the ohmic contact layer 150 having relatively low resistance, whereby high-current stress on the diodes in the active region AR may be relieved.

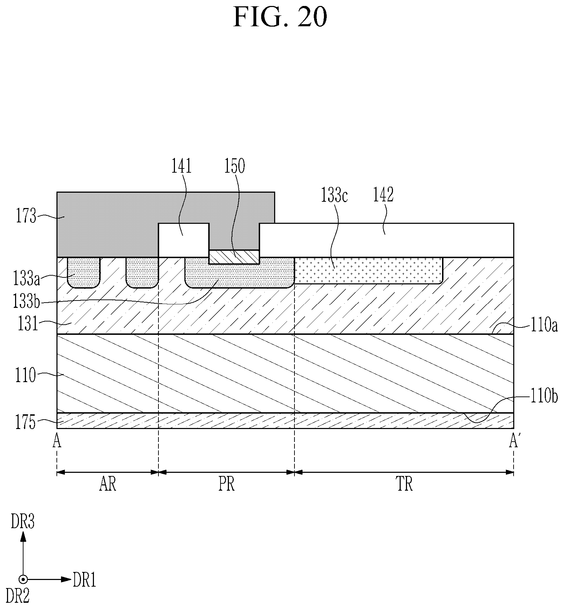

Referring to FIG. 20, the second electrode 175 may be formed on the second surface 110b of the substrate 110. Depending on the voltage which is applied between the first electrode 173 and the second electrode 175, current may flow in the diodes positioned in the active region AR from the first electrode 173 toward the second electrode 175.

## Claims

1. A semiconductor device comprising:
a substrate (110) including an active region (AR), a termination region (TR) outside the active region (AR), and a peripheral region (PR) between the active region (AR) and the termination region (TR);
a semiconductor layer (131) on a first surface (110a) of the substrate (110), the semiconductor layer (131) having a first conductivity type;
a doping region (133a) inside the semiconductor layer (131) in the active region (AR), the doping region (133a) having of a second conductivity type different than the first conductivity type;
a peripheral doping region (133b) inside the semiconductor layer (131) in the peripheral region (PR), the peripheral doping region (133b) having the second conductivity type;
a first electrode (173) on the semiconductor layer (131), the doping region (133a), and the peripheral doping region (133b);
a second electrode (175) on a second surface (110b) of the substrate (110), the second surface (110b) opposite the first surface (110a);
an ohmic contact layer (150) between the peripheral doping region (133b) and the first electrode (173), the ohmic contact layer (150) containing a metal silicide material; and
a first insulating pattern (141) between the ohmic contact layer (150) and the first electrode (173), the first insulating pattern (141) being adjacent to the ohmic contact layer (150) in a direction (DR1, DR2) parallel with the first surface (110a) of the substrate (110).

2. The semiconductor device of claim 1, wherein
the doping region (133a) and the semiconductor layer (131) abut with the first electrode (173).

3. The semiconductor device of claim 1 or 2, further comprising:
a termination doping region (133c) inside the semiconductor layer (131) in the termination region (TR), the termination doping region (133c) having the second conductivity type,
wherein the termination doping region (133c) has a doping concentration lower than a doping concentration of the peripheral doping region (133b).

4. The semiconductor device of claim 3, further comprising:
a second insulating pattern (142) on the peripheral doping region (133b), the termination doping region (133c), and the semiconductor layer (131),
wherein the ohmic contact layer (150) is between the first insulating pattern (141) and the second insulating pattern (142), wherein optionally one side surface of the ohmic contact layer (150) abuts with the first insulating pattern (141), and wherein optionally another side surface of the ohmic contact layer (150) abuts with the second insulating pattern (142).

5. The semiconductor device of any one of the previous claims, wherein a work function difference between the ohmic contact layer (150) and the peripheral doping region (133b) is smaller than a work function difference between the first electrode (173) and the peripheral doping region (133b).

6. The semiconductor device of any one of the previous claims, wherein
a lower surface of the ohmic contact layer (150) is at a lower level than an upper surface of the peripheral doping region (133b), and an upper surface of the ohmic contact layer (150) is positioned at a higher level than the upper surface of the peripheral doping region (133b).

7. The semiconductor device of any one of the previous claims, wherein
a width of the ohmic contact layer (150) is less than a width of the peripheral doping region (133b).

8. The semiconductor device of any one of the previous claims, wherein
the peripheral doping region (133b) and the ohmic contact layer (150) have ring shape in a plan view.

9. The semiconductor device of any one of the previous claims, wherein
the first insulating pattern (141) extends along an inner side surface of the ohmic contact layer (150).

10. The semiconductor device of any one of the previous claims, wherein
at least a portion of the first insulating pattern (141) overlaps the peripheral doping region (133b) in a direction (DR3) perpendicular to the first surface (110a) of the substrate (110).

11. The semiconductor device of any one of the previous claims, wherein
the first insulating pattern (141) is outside of the active region (AR), and the first insulating pattern (141) abuts with the semiconductor layer (131) and the peripheral doping region (133b).

12. The semiconductor device of any one of claims 1 to 10, wherein
the first insulating pattern (141) abuts with the peripheral doping region (133b), and the first insulating pattern (141) does not abut with the semiconductor layer (131) in the peripheral region (PR).

13. The semiconductor device of any one of claims 1 to 10, wherein
a portion of the first insulating pattern (141) is in the active region (AR), and another portion of the first insulating pattern (141) is in the peripheral region (PR).

14. The semiconductor device of any one of the previous claims, wherein:
a portion of the first electrode (173) in the active region (AR) and a portion of the first electrode (173) in the peripheral region (PR) are connected on an upper surface of the first insulating pattern (141).

15. A method of manufacturing a semiconductor device that includes:
implanting an impurity into an upper portion of a semiconductor layer (131) to form a doping region (133a) and a peripheral region (PR), the semiconductor layer (131) having a first conductivity type, and the doping region (133a) and the peripheral region (PR) having a second conductivity type different than the first conductivity type, the semiconductor layer (131) being on a first surface (110a) of a substrate (110) including an active region (AR), a termination region (TR) outside the active region (AR), and a peripheral region (PR) between the active region (AR) and the termination region (TR), and the doping region (133a) being in the active region (AR) and the peripheral doping region (133b) being in the peripheral region (PR);
forming an insulating layer (140) on the semiconductor layer (131), the doping region (133a), and the peripheral doping region (133b);
forming a first photoresist pattern (PR1) on the insulating layer (140);
forming a first insulating pattern (141) and a second insulating pattern (142) by etching the insulating layer (140) using the first photoresist pattern (PR1) as a mask, the first insulating pattern (141) being spaced apart from the second insulating pattern (142) in a direction (DR1, DR2) parallel to the first surface (110a) of the substrate (110);
forming an ohmic contact layer (150) on the peripheral doping region (133b) between the first insulating pattern (141) and the second insulating pattern (142);
removing the first photoresist pattern (PR1);
forming a second photoresist pattern (PR2) covering the ohmic contact layer (150), the second insulating pattern (142) and a portion of the first insulating pattern (141);
removing a portion of the first insulating pattern (141) by etching the first insulating pattern (141) using the second photoresist pattern (PR2) as a mask;
removing the second photoresist pattern (PR2); and
forming a first electrode (173) abutting the doping region (133a), the semiconductor layer (131), and the ohmic contact layer (150).

## Amended claims

### Amended claims in accordance with Rule 137(2) EPC.

1. A semiconductor device comprising:
a substrate (110) including an active region (AR), a termination region (TR) outside the active region (AR), and a peripheral region (PR) between the active region (AR) and the termination region (TR);
a semiconductor layer (131) on a first surface (110a) of the substrate (110), the semiconductor layer (131) having a first conductivity type;
a doping region (133a) inside the semiconductor layer (131) in the active region (AR), the doping region (133a) having a second conductivity type different than the first conductivity type;
a peripheral doping region (133b) inside the semiconductor layer (131) in the peripheral region (PR), the peripheral doping region (133b) having the second conductivity type;
a first electrode (173) on the semiconductor layer (131), the doping region (133a), and the peripheral doping region (133b);
a second electrode (175) on a second surface (110b) of the substrate (110), the second surface (110b) opposite the first surface (110a);
an ohmic contact layer (150) between the peripheral doping region (133b) and the first electrode (173), the ohmic contact layer (150) containing a metal silicide material;
a first insulating pattern (141) between the ohmic contact layer (150) and the first electrode (173), the first insulating pattern (141) being adjacent to the ohmic contact layer (150) in a direction (DR1, DR2) parallel with the first surface (110a) of the substrate (110);
a termination doping region (133c) inside the semiconductor layer (131) in the termination region (TR), the termination doping region (133c) having the second conductivity type, wherein the termination doping region (133c) has a doping concentration lower than a doping concentration of the peripheral doping region (133b); and
a second insulating pattern (142) on the peripheral doping region (133b), the termination doping region (133c), and the semiconductor layer (131),
wherein the ohmic contact layer (150) is between the first insulating pattern (141) and the second insulating pattern (142), wherein one side surface of the ohmic contact layer (150) abuts with the first insulating pattern (141), and wherein another side surface of the ohmic contact layer (150) abuts with the second insulating pattern (142).

2. The semiconductor device of claim 1, wherein
the doping region (133a) and the semiconductor layer (131) abut with the first electrode (173).

3. The semiconductor device of any one of the previous claims, wherein a work function difference between the ohmic contact layer (150) and the peripheral doping region (133b) is smaller than a work function difference between the first electrode (173) and the peripheral doping region (133b).

4. The semiconductor device of any one of the previous claims, wherein
a lower surface of the ohmic contact layer (150) is at a lower level than an upper surface of the peripheral doping region (133b), and an upper surface of the ohmic contact layer (150) is positioned at a higher level than the upper surface of the peripheral doping region (133b).

5. The semiconductor device of any one of the previous claims, wherein
a width of the ohmic contact layer (150) is less than a width of the peripheral doping region (133b).

6. The semiconductor device of any one of the previous claims, wherein
the peripheral doping region (133b) and the ohmic contact layer (150) have ring shape in a plan view.

7. The semiconductor device of any one of the previous claims, wherein
the first insulating pattern (141) extends along an inner side surface of the ohmic contact layer (150).

8. The semiconductor device of any one of the previous claims, wherein
at least a portion of the first insulating pattern (141) overlaps the peripheral doping region (133b) in a direction (DR3) perpendicular to the first surface (110a) of the substrate (110).

9. The semiconductor device of any one of the previous claims, wherein
the first insulating pattern (141) is outside of the active region (AR), and the first insulating pattern (141) abuts with the semiconductor layer (131) and the peripheral doping region (133b).

10. The semiconductor device of any one of claims 1 to 8, wherein
the first insulating pattern (141) abuts with the peripheral doping region (133b), and the first insulating pattern (141) does not abut with the semiconductor layer (131) in the peripheral region (PR).

11. The semiconductor device of any one of claims 1 to 8, wherein
a portion of the first insulating pattern (141) is in the active region (AR), and another portion of the first insulating pattern (141) is in the peripheral region (PR).

12. The semiconductor device of any one of the previous claims, wherein: a portion of the first electrode (173) in the active region (AR) and a portion of the first electrode (173) in the peripheral region (PR) are connected on an upper surface of the first insulating pattern (141).

13. A method of manufacturing a semiconductor device that includes:
implanting an impurity into an upper portion of a semiconductor layer (131) to form a doping region (133a) and a peripheral doping region (133b), the semiconductor layer (131) having a first conductivity type, and the doping region (133a) and the peripheral doping region (133b) having a second conductivity type different than the first conductivity type, the semiconductor layer (131) being on a first surface (110a) of a substrate (110) including an active region (AR), a termination region (TR) outside the active region (AR), and a peripheral region (PR) between the active region (AR) and the termination region (TR), and the doping region (133a) being in the active region (AR) and the peripheral doping region (133b) being in the peripheral region (PR);
forming an insulating layer (140) on the semiconductor layer (131), the doping region (133a), and the peripheral doping region (133b);
forming a first photoresist pattern (PR1) on the insulating layer (140);
forming a first insulating pattern (141) and a second insulating pattern (142) by etching the insulating layer (140) using the first photoresist pattern (PR1) as a mask, the first insulating pattern (141) being spaced apart from the second insulating pattern (142) in a direction (DR1, DR2) parallel to the first surface (110a)of the substrate (110);
forming an ohmic contact layer (150) on the peripheral doping region (133b) between the first insulating pattern (141) and the second insulating pattern (142);
removing the first photoresist pattern (PR1);
forming a second photoresist pattern (PR2) covering the ohmic contact layer (150), the second insulating pattern (142) and a portion of the first insulating pattern (141);
removing a portion of the first insulating pattern (141) by etching the first insulating pattern (141) using the second photoresist pattern (PR2) as a mask;
removing the second photoresist pattern (PR2); and
forming a first electrode (173) abutting the doping region (133a), the semiconductor layer (131), and the ohmic contact layer (150).
